# EUROPEAN PATENT APPLICATION

(11) **EP 4 002 414 A1**
(43) Date of publication of application: **25.05.2022**
(21) Application number: 20207564.4
(22) Date of filing: 13.11.2020
(51) Int. Cl.: H01H 50/02, H05K 5/06, H01H 49/00

(54) **ELECTRIC DEVICE COMPRISING A SEALED HOUSING HAVING A LOWER HOUSING PART AND AN UPPER HOUSING PART**

(71) Applicant: Tyco Electronics Austria GmbH, 1190 Wien (AT)
(72) Inventor: GUTMANN, Markus, 1210 Wien (AT); DEIMLING, Guenther, 1210 Wien (AT); WESELY, Bernd, 1210 Wien (AT)
(74) Representative: Grünecker Patent- und Rechtsanwälte PartG mbB

(57) **Abstract**

The invention relates to an electric device (1) comprising electric components (2) and a housing (4). The housing (4) has a lower housing part (6), on which at least one of the electric components (2) is supported, and an upper housing part (8), wherein a weld (10) is formed between the lower housing part (6) and the upper housing part (8). The lower housing part (6) and the upper housing part (8) surround a housing volume (12), in which the electric components (2) are sealingly encased. One of the lower housing part (6) and the upper housing part (8) comprises a protrusion (14), which is welded to the respective other one of the lower housing part (6) and upper housing part (8), wherein a gap (16) is provided between the lower housing part (6) and the upper housing part (8), the gap (16) extending radially from the protrusion (14) to outside (17) of the housing (4) and wherein solidified molten material (18) of the weld (10) is received at least partially in the gap (16).

## Description

The invention relates to an electric device, such as a relay. The electric device comprises electric components and a sealed housing having a lower housing part and an upper housing part encasing the electric components. The invention further relates to a method for assembling a housing of such an electric device.

Such electric devices are often subjected to high inside pressure, which may occur due to high ambient and/or operating temperatures. Furthermore, fast temperature changes in combination with humidity inside the housing may also increase the inside pressure. The inside pressure may deform and/or damage the housing. Some applications require a high level of sealing, in order to protect the electric components within the housing and prevent a short circuit and/or contact failure. The prior art teaches inserting the electric components into a housing part, closing the housing part with a planar cover and sealing the housing with either temperature or UV hardening epoxies. The application of epoxies, however, is disadvantageous as the hardening process of the epoxies may apply high thermal stress on the product. Furthermore, the precise application of an epoxy is cumbersome and the epoxy flow has to be controlled by a variety of design elements on the housing parts, which may reduce the durability of the housing.

Therefore, an objective of the invention is to provide an electric device that is easily manufactured and has a durable sealed housing.

The invention solves the above-mentioned problem by providing an electric device, such as a relay, the electric device comprising electric components and a housing. The housing has a lower housing part, on which at least one of the electric components is supported, and an upper housing part, wherein a weld is formed between the lower housing part and the upper housing part. The lower housing part and the upper housing part surround a housing volume, in which the electric components are sealingly encased. One of the lower housing part and the upper housing part comprises a protrusion, which is welded to the respective other one of the lower housing part and upper housing part, wherein a gap is provided between the lower housing part and the upper housing part, the gap extending radially from the protrusion to the outside of the housing and wherein solidified molten material of the weld is received at least partially in the gap.

The above-mentioned objective is further achieved by a method for assembling a housing of an electric device, the housing comprising a lower housing part for supporting at least one electric component and an upper housing part, wherein one of the lower housing part and the upper housing part comprises a protrusion, which is pressed against and welded to the respective other one of the lower housing part and the upper housing part and wherein a gap is formed between the lower housing part and upper housing part extending radially from the protrusion to the outside of the housing molten material from the welding process is at least partially received in the gap.

The inventive electric device and method for assembling a housing of an electric device provide a robust housing with excellent sealing performance. The protrusion as well as the solidified molten material act as a barrier preventing any ingress of fluids into the housing at the interface between the upper housing part and the lower housing part and thus hermetically seal the housing volume encased by the housing parts. Consequently, the cumbersome application of epoxies for sealing is avoided, Hence, there is no need to provide design elements on the housing parts to direct the epoxies, which would reduce the durability of the housing parts.

The gap extending radially from the protrusion to outside the housing forms a collection chamber for collecting excessive material formed during welding. Furthermore, the gap prevents additional welding zones from being formed as the upper housing part abutting the lower housing part outside the predetermined welding zone defined by the interface of the protrusion and the respective other of the lower housing part and the upper housing part is prevented. However, the molten material of the protrusion received in the gap bonds the lower and upper housing part to one another when solidifying and thus increases the surface area and strength of the weld joint.

It is possible to clearly identify the inventive electric device via common structural analysis, such as plastography or X-ray testing. The solidified molten material will be apparent due to its different microstructure. For example, the orientation of the particles and density of the solidified molten material can be different to that of the protrusion and the respective housing parts. Consequently, the solidified molten material can be distinguished from the protrusion and the respective housing parts and it is thus possible to verify the protrusion being welded to the respective other one of the lower housing part and upper housing part as well as the presence of the solidified molten material in the gap between the lower housing part and upper housing part.

Furthermore, it should be noted that the term "radially" within the context of this application is not limited to circular structures and may be used synonymously with laterally or to mean perpendicular to a peripheral direction of the housing.

The invention can be further improved by the following features, which are independent from one another as regards their respective technical effects and which can be combined arbitrarily.

For example, the upper housing part and the lower housing part may be welded to one another without any welding additives, meaning that no supplementary welding material is added during the welding process for forming a weld seam. When the upper housing part and the lower housing part are formed from different materials such as plastic and metal or a thermoplastic and a thermoplastic elastomer, the weld is preferably formed by laser welding.

However, according to a preferred embodiment, an ultrasonic weld is formed between the upper housing part and the lower housing part. During the welding process a welding tool, such as a sonotrode, generates high-frequency vibrations of about 20 to 25 kHz or even up to 50 kHz, which are transferred, in combination with pressure, to the parts to be joined, which leads to relative vibrations in the jointing zone. Ultrasonic welding is particularly advantageous as only the components that directly abut one another form a vibration barrier, causing vibration energy to be absorbed and converted into heat. This in turn causes melting of a tip of the protrusion, which forms the weld when solidifying. The heat is exclusively generated at the tip of the protrusion, such that the remainder of the housing is not subject to thermal stress. Due to the focused energy input, extremely short welding times may be achieved.

In order to ensure a consistent weld along the peripheral direction and to prevent any weak spots, the protrusion may extend continuously along the peripheral direction, preferably along the entire periphery of the respective lower housing part or upper housing part.

The protrusion is preferably received in a notch of the respective other one of the lower housing part and upper housing part, wherein the solidified molten material is at least partially received in a space between the notch and the protrusion. Consequently, a large surface area is provided for welding the protrusion to the respective other one of the lower housing part and the upper housing part.

A width of the notch may preferably be larger than a width of the protrusion in the radial direction such that only a front face of the protrusion abuts a bottom surface of the notch. Therefore, the interface between notch and protrusion may be limited to the front face of the protrusion allowing a further controlling of the welding zone. The protrusion and the notch may particularly form a tongue and groove assembly, which allows for a particularly rigid weld. A capillary effect ensures that the molten material flows into the space between the protrusion and the notch.

Preferably, the gap may extend in the radial direction beyond the solidified molten material, particularly the solidified molten material received in the gap, in order to prevent the molten material from flowing to the outside of the housing. The gap may be dimensioned such that a volume of the molten material, which can be predetermined by defining the welding time and/or depth at which the tip of the protrusion is pressed against the respective other one of the lower housing part and upper housing part, is lower than the volume between the housing parts. The volume between the housing parts may be defined as the sum of the space between protrusion and notch, the volume of the gap and the volume of any further gaps into which the molten material may flow during welding.

By preventing the molten material from flowing out of the housing, further processing steps, such as a cleaning step to provide a smooth outer surface may be avoided.

The upper housing part and/or the lower housing part may comprise a plastic material, particularly a glass fiber reinforced material, which may further increase the rigidity of the housing parts.

For further providing a collection chamber for the molten material arranged between housing volume and protrusion, a second, inner gap between the housing parts may be provided, extending radially from the protrusion to the housing volume. Consequently, solidified molten material may also at least partially be received in the inner gap, further increasing the surface area of the weld without generating excessive molten material.

The inner gap may preferably be arranged opposite to the gap relative to the protrusion such that the molten material can be collected at either side of the protrusion without spilling into the housing volume or out of the housing.

The gap and the inner gap may preferably be aligned such that they are arranged on the same plane essentially parallel to the radial direction. Preferably, the width of the gap and the inner gap, essentially perpendicular to the radial direction and peripheral direction, may be principally the same, in order to ensure an essentially homogeneous welding zone.

Consequently, a collection chamber is provided both radially inwards and radially outwards from the welding zone. Therefore, the molten material may be prevented from moving inside into the housing volume and outside the housing, as it is securely confined in the inner gap and the gap.

If the protrusion is received in the notch, the notch preferably opens into the gap and, if applicable, into the inner gap. Therefore, a direct flow of the molten material into the gap and inner gap is possible. The combination of the notch and the gap and/or inner gap is particularly advantageous since particles, e.g. glass fiber particles, released during welding at the welding zone flowing out of the notch are then further redirected by approximately 90° via the gap and inner gap, respectively. This redirection may slow down the particle flow so that it can be caught up in the gap and inner gap, respectively, by the molten material and thus be diffused in the solidified molten material.

The particles flowing to the outside may cause irritation to surrounding people and/or may damage surrounding components. However, as the particles may be trapped in the gap, the particles are prevented from flowing to the outside, avoiding the need for additional safety equipment.

In order to further prevent any additional welding zones from occurring during welding, only the protrusion may abut the respective other one of the lower housing part and the upper housing part. In other words, there is no further immediate contact surface between the lower housing part and the upper housing part besides the contact surface provided by the protrusion and the surface being abutted by the protrusion. Hence, material melting at different areas other than the welding zone of the protrusion and the abutting surface is avoided. Said melting material at undesired additional areas may, for example, cause an overflow of molten material and/or an excessive release of particles in the molten material, such as glass fibers. This may negatively affect the product quality and even lead to contact failure of the electric components received in the housing volume.

Therefore, in this advantageous embodiment, the upper housing part and/or the lower housing part does not comprise a limitation surface to define the distance at which the housing parts are pushed towards each other during the welding process, i.e. until abutment of the limitation surface to the respective other one of the lower housing part and upper housing part. The distance may instead be determined directly by the welding process, e.g. via the welding time and pushing force. The omission of the limitation surface has the further advantage in that the gaps are not being closed by the limitation surface preventing squeezing out of the molten material arranged in the gap during welding.

In accordance with a further advantageous embodiment, the lower housing part and/or the upper housing part may be essentially tub-shaped having a sidewall extending essentially parallel to a plane essentially perpendicular to the radial direction. The protrusion may be formed on a front face of the respective lower housing part's or upper housing part's sidewall, the front face facing a front face of the respective other one of the lower housing part's and upper housing part's sidewall.

Consequently, the gap and/or inner gap may be formed between the front faces of the respective sidewalls facing each other and extending radially from the protrusion.

Should the durability of the housing be further increased, an outer surface of the lower housing part's sidewall may preferably be aligned with an outer surface of the upper housing part's sidewall. The outer surfaces may be arranged on a common plane essentially perpendicular to the radial direction. Consequently, no radially outward protruding step is formed between the upper housing part and the lower housing part, which may be susceptible to chipping.

According to a further advantageous embodiment, one of the lower housing part and upper housing part may comprise an inner wall arranged in the housing volume and project towards the respective other one of the lower housing part and upper housing part. The inner wall may preferably extend essentially parallel to the sidewalls of the respective other one of the lower housing part and upper housing part, forming a slot-like pocket between them.

The inner gap may preferably open into the slot-like pocket, such that the inner wall acts as a barrier preventing any particles of the molten material from flowing into the housing volume and contacting the electric components. Such particles may potentially damage the electric components and may even cause a contact failure, particularly if the molten material comprises glass fibers or other reinforcement particles. Hence, a maze-like pathway is created for the particles to flow from the welding zone to the electric components mounted in the housing volume. First, the particles flow in a first direction from the welding zone into the inner gap, where they are redirected to a second direction, which is essentially perpendicular to the first direction. This may slow the particle flow down so that the molten material may catch up and trap the particles upon solidifying in the gap.

However, a further fail safe is provided in that the particles that manage to escape from the inner gap are not directly lead to the electric components in the housing volume. Instead, they are received in the slot-like pocket. A second redirection into a third direction, essentially perpendicular to the second direction and essentially parallel to the first direction, would be necessary for the particles to flow out of the slot-like pocket beyond the inner wall to the electric components.

The inner wall and the protrusion may be preferably formed on different housing parts. For example, the inner wall may be formed on the lower housing part and thus also act as a stabilizing structure for mounting the electric components. The upper housing part may comprise the protrusion extending from the front face of the upper housing part's sidewall.

In order to further increase the rigidity of the weld, the front face of the lower housing part's sidewall may extend as a radially protruding shoulder from the inner wall to the outside of the housing. Consequently, the sidewall of the lower housing part comprises a high material thickness in the radial direction and is further reinforced by the inner wall. This may be of particular advantage when the front face of the lower housing part comprises a notch in which the protrusion is received. During welding, particularly ultrasonic welding, the vibrational strain on the sidewall of the lower housing part may be compensated by the increased rigidity due to the high material thickness, preventing any damage to the housing part and thus further reducing the risk of production faults.

According to a further advantageous embodiment, the gap may be arranged between a quarter and three quarters of a height of the housing. Therefore, both the upper and the lower housing part may be stabilized by the respective sidewalls, and a distortion due to welding may be prevented.

In particular, bulging of a housing part due to high inside pressure may be avoided, especially if the housing parts have a longitudinal body meaning that a length of the housing parts is greater than a width and/or height of the housing. The durability of the housing and reliability of the welded seal may even be further increased when the gap is arranged at mid-height of the housing. It should be noted that a deviation of an eighth from a center plane of the housing arranged essentially parallel to the radial direction is also considered as mid-height of the housing within the context of this application.

In the following, the housing assembly according to the invention is explained in greater detail with reference to the accompanying drawings, in which exemplary embodiments are shown.

In the figures, the same reference numerals are used for elements which correspond to one another in terms of their function and/or structure.

According to the description of the various aspects and embodiments, elements shown in the drawings can be omitted if the technical effects of those elements are not needed for a particular application, and *vice versa*: i.e., elements that are not shown or described with reference to the figures, but which are described above can be added if the technical effect of those particular elements is advantageous in a specific application.

In the figures
- Fig. 1: shows a schematic sectional view of an exemplary embodiment of the inventive electric device;
- Fig. 2: shows a schematic enhanced view of a protrusion of the exemplary embodiment shown in Fig. 1 before welding;
- Fig. 3: shows a schematic perspective view of a housing of an electric device during welding; and
- Fig. 4: shows a schematic enhanced view of the protrusion of the exemplary embodiment shown in Fig. 1 after welding.

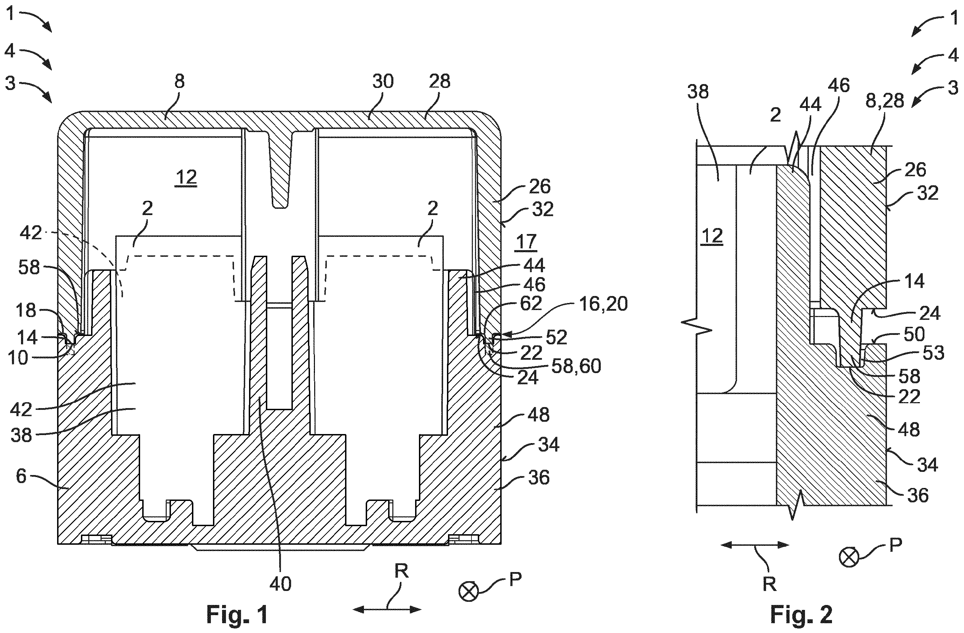

First, an exemplary embodiment of the inventive electric device 1 is further explained in detail with reference to Fig. 1, which shows the electric device 1 in a schematic perspective view.

The electric device 1 comprises electric components 2 and a housing 4. The housing 4 has a lower housing part 6, on which at least one of the electric components 2 is supported, and an upper housing part 8, wherein a weld 10 is formed between the lower housing part 6 and the upper housing part 8. The lower housing part 6 and the upper housing part 8 surround a housing volume 12, in which the electric components 2 are sealingly encased. One of the lower housing part 6 and the upper housing part 8 comprises a protrusion 14, which is welded to the respective other one of the lower housing part 6 and upper housing part 8, wherein a gap 16 is provided between the lower housing part 6 and the upper housing part 8, the gap 16 extending radially from the protrusion 14 to outside 17 of the housing 4 and wherein solidified molten material 18 of the weld 10 is received at least partially in the gap 16.

In Fig. 1, the electric components 2 are only schematically indicated. The electric device 1 may particularly be a relay 3, whereby the electric components 2 may for example include a contact spring, a coil or the like.

The protrusion 14 as well as the solidified molten material 18 act as a barrier preventing any ingress of fluids into the housing 4 at an interface between upper housing part 8 and lower housing part 6 and therefore hermetically sealing the housing volume 12 encased by the housing parts 6, 8. Consequently, cumbersome application of epoxies for sealing is avoided. Hence, there is no need of design elements on the housing parts to direct the epoxies, which would reduce the durability of the housing parts. Particularly, the housing 4 may not be sealed with epoxies.

The gap 16 extending radially from the protrusion 14 to the outside of the housing 4 acts as a collection chamber 20 for collecting excessive material formed during welding and at the same time prevents additional welding zones being formed by the upper housing part abutting the lower housing part outside a predetermined welding zone 22 defined by the interface of the protrusion 14 and the respective other of the lower housing part 6 and the upper housing part 8. However, the molten material of the protrusion 14 being received in the gap 16 bonds the lower and upper housing part 6, 8 to one another when solidifying and thus increases the surface area and strength of the weld ten.

It is to be noted that the radial direction R is not limited to a spherical housing. The housing 4 may also comprise a cuboid shape, in which case the radial direction R is to be understood as being essentially perpendicular to a peripheral direction P of the electric device 1.

As can be seen in Fig. 1, the protrusion 14 may preferably be formed on a front face 24 of the upper housing part's 8 sidewall 26. The upper housing part 8 may preferably be a tub-shaped cover 28 having an upper wall 30 and the sidewall 26 extending essentially perpendicular from the upper wall 30 towards the lower housing part 6. In a particularly advantageous embodiment, the sidewall 26 may be formed monolithically with the upper wall 30 and extend along a closed periphery. Consequently, further sealing between the sidewall and upper wall 30 is no longer necessary.

Preferably, the protrusion 14 extends continuously in the peripheral direction P and thus also has a closed periphery. Therefore, the sealing provided by the weld is the same at each position along the peripheral direction P, preventing any weak spots for fluid ingress.

The sidewall 26 may comprise an outer surface 32 facing the outside 17, which may preferably be aligned with an outer surface 34 of the lower housing part's sidewall 36, in a plane essentially perpendicular to the radial direction R. In other words, the outer surfaces 32, 34 may be arranged on a common plane extending essentially perpendicular to the radial direction R.

The lower housing part 6 may comprise compartments 38, in which the electric components 2 may be mounted. The compartments 38 may be separated from one another via ribs 40 or bulkhead walls 42, which are indicated with the phantom lines in Fig. 1.

In order to limit the compartments 38 in the radially outward facing direction, an inner wall 44 may be provided, the inner wall 44 extending essentially parallel to the sidewalls 26 of the upper housing part 8 and projecting into a volume surrounded by the upper housing part 8, so that a slot-like pocket 46 is formed between the inner wall 44 and the sidewalls 26.

A radially protruding shoulder 48 protruding from the inner wall 44 may form the outwards facing sidewall 36 of the lower housing part 6. Therefore, the sidewall 36 of the lower housing part 6 has an increased rigidity due to the high material thickness in the radial direction R. With the radially protruding shoulder 48 a front face 50 is provided facing the upper housing part 8, such that the gap 16 may be formed between the respective front faces 24, 50 of the upper and lower housing parts 8, 6.

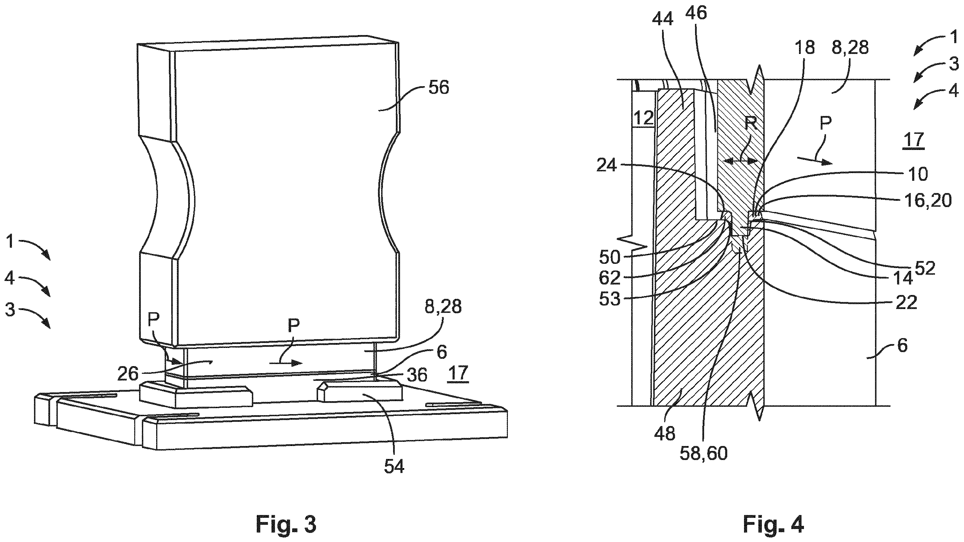

In order to further strengthen the weld 10, a notch 52 may be formed on the front face 50 of the lower housing part 6, the notch 52 at least partially receiving the protrusion 14. Therefore, a tongue-groove weld may be formed between the notch 52 and the protrusion 14. The notch 52 may have a width in the radial direction R which is greater than a width of the protrusion in a radial direction 14, such that a space 53 is formed between notch 52 and protrusion 14, which is filled with the solidified molten material 18, providing a strong and durable weld 10 (see Fig. 4).

As can be seen in Fig. 1, the gap 16 may be arranged preferably at around mid-height of the housing 4, which is particularly advantageous, as both the lower housing part 6 and the upper housing part 8 are stabilized by their respective sidewalls. Especially for housings 4 having a longitudinal body such an embodiment may prove particularly advantageous, as bulging due to high inside pressure as well as distortion due to the welding process may be avoided.

Now, the welding process as well as the weld is further discussed with references to Figs. 2 to 4.

In Fig. 2, an enhanced section of the housing parts is shown before welding. As can be seen, only the protrusion 14 abuts the lower housing part 6, as a front face of the protrusion 14 is pressed against a bottom surface of the notch 52. Consequently, the welding zone may be restricted to said interface and generation of additional and unwanted molten material during the welding process may be prevented. Material melting at different areas other than the welding zone 22 of the protrusion 14 and the abutting surface is avoided. Said melting material at undesired additional areas may, for example, cause an overflow of molten material and/or an excessive release of reinforcement particles, such as glass fibers. This may negatively affect the product quality and even lead to contact failure of the electric components received in the housing volume, since there are no provisions to prevent a direct flow of the molten material and/or the reinforcement particles to the electric components 2 or the outside 17 of the housing 4 at the additional welding zones.

The protrusion 14 may have a length that is larger than a depth of the notch 52, so that the front faces 24, 50 are spaced apart from one another. Preferably, the protrusion 14 may be arranged at an essentially central position of the front face 24 in the radial direction R, such that a part of the front face 24 extends radially inwards or radially outwards beyond the protrusion 14.

If the addition of a supplementary welding material should be avoided, the housing parts 6, 8 may preferably be welded to one another via ultrasonic welding. Such a process is shown in Fig. 3. For this, the lower housing part 6 may be mounted securely on a base platform 54 and the upper housing part 8 is placed onto the lower housing part 6. A sonotrode 56 presses the upper housing part 8 towards the lower housing part 6, while simultaneously emitting a low-amplitude acoustic vibration of about 20 to 25 kHz or even up to 50 kHz. Due to the vibration, high friction is generated between the abutting parts of the housing parts, which in this case is a front face of the protrusion and a bottom surface of the notch. This friction causes only a tip 58 of the protrusion to melt, so that the thermal stress is limited to a relatively small zone, without affecting the characteristics of the remainder of the housing parts. In Figs. 1 and 4, said molten tip 58 is indicated with phantom lines and comprises a predetermined volume 60, which can be determined by the depth that the housing parts are pressed towards one another and the duration of the welding process.

The molten material fills up the space between protrusion 14 and notch 52. Preferably, the notch opens into the gap 16, which may be formed between the opposing front faces 24,k 50 of the housing parts 6, 8. Therefore, the molten material may further flow into the gap and weld the front faces 24, 50 to one another upon solidifying. Consequently, not only the protrusion is welded to the notch, but also the front faces to one another, without directly abutting each other.

As can be seen in Figs. 2 and 4, the notch 52 may further open into an inner gap 62 opposite the gap 16 formed between the parts of the front faces extending radially inwards from the protrusion and notch, respectively. With this additional inner gap 62, further formations of welding zones may be prevented. Preferably, only the protrusion 14 may directly abut the respective other one of the lower housing part 6 and upper housing part 8, so that the weld 10 can be further optimized and controlled. The occurrence of an additional welding zone may be prevented when after the welding process only the protrusion 14 abuts the respective other one of the lower housing part 6 and upper housing part 8.

The inner gap 62 may preferably be arranged directly opposite the gap 16 relative to the protrusion 14, so that they extend along a common plane essentially parallel to the radial direction R. Particles which arise during welding should be prevented from coming into contact with the electric components, therefore the inner gap 62 may open into the slot-like pocket 46. Thus, the inner wall 44 may act as a further barrier forming a maze-like pathway for the particles to come into contact with the electric components.

Preferably, the housing parts 6, 8 may be formed of a plastic material, which may be reinforced by glass fibers, for example. Therefore, a contact of the glass fibers with the electric components may be prevented, which may even cause a contact failure.

In order for the particles to reach the electric contacts 2 they need to flow from the welding zone 22 into the inner gap 62, where they are redirected radially inwards. This may slow the particle flow down so that the molten material may catch up and trap the particles upon solidifying in the inner gap 62. Correspondingly, the particles trying to flow out of the housing 4 are redirected and eventually trapped in the gap 16.

The particles are further prevented from reaching the electric components 2 by the inner wall 44. The particles that manage to escape from the inner gap 62 are not directly lead to the electric components 2 in the housing volume 12. Instead, they are received in the slot-like pocket 46. A second redirection of the particles would be necessary for the particles to flow out of the slot-like pocket 46 beyond the inner wall 44 to the electric components 2.

Fig. 4 shows the weld 10 of the assembled housing 4. The solidified molten material 18 may preferably be received in both the inner gap 62 and the gap 16 forming an intermediate layer bonding the front faces 24, 50 of the housing parts 6, 8 to one another. The gap 16 and the inner gap 62 may preferably extend radially beyond the solidified molten material preventing any of the molten material from spilling to the outside and thus requiring further processing steps for smoothening the outer surfaces 32, 34 after solidifying or potentially damaging the electric components 2.

This may be achieved, for example, if the predetermined volume is smaller than the sum of a volume of the space between protrusion and notch, a volume of the inner gap after the welding process and a volume of the gap after the welding process.

### REFERENCE NUMERALS

- 1: electric device
- 2: electric component
- 3: relay
- 4: housing
- 6: lower housing part
- 8: upper housing part
- 10: weld
- 12: housing volume
- 14: protrusion
- 16: gap
- 17: outside
- 18: solidified molten material
- 20: collection chamber
- 22: predetermined welding zone
- 24: front face
- 26: sidewall
- 28: tub-shaped cover
- 30: upper wall
- 32: outer surface
- 34: outer surface
- 36: sidewall
- 38: compartment
- 40: rib
- 42: bulkhead wall
- 44: inner wall
- 46: slot-like pocket
- 48: shoulder
- 50: front face
- 52: notch
- 53: space
- 54: base platform
- 56: sonotrode
- 58: tip
- 60: predetermined volume
- 62: inner gap
- P: peripheral direction
- R: radial direction

## Claims

1. Electric device (1), such as a relay (3), the electric device (1) comprising:
- electric components (2);
- a sealed housing (4) having:
- a lower housing part (6), on which at least one of the electric components (2) is supported; and
- an upper housing part (8), wherein a weld (10) is formed between the upper housing part (8) and the lower housing part (8);
the lower housing part (6) and the upper housing part (8) surrounding a housing volume (12), in which the electric components (2) are sealingly encased, wherein one of the lower housing part (6) and the upper housing part (8) comprises a protrusion (14), which is welded to the respective other one of the lower housing part (6) and upper housing part (8), and wherein a gap (16) is provided between lower housing part (6) and upper housing part (8), the gap (16) extending radially from the protrusion (14) to an outside (17) of the housing (4), and wherein solidified molten material (18) from the weld (10) is at least partially received in the gap (16).

2. Electric device (1) according to claim 1, wherein the protrusion (14) extends continuously along an entire front face (24) of the respective lower housing part (6) or upper housing part (8) and has a closed periphery.

3. Electric device (1) according to claim 1 or 2, wherein the protrusion (14) is at least partially received in a notch (52) of the respective other one of the lower housing part (6) and upper housing part (8) and wherein the weld (10) is at least partially arranged between protrusion (14) and notch (52).

4. Electric device (1) according to any one of claims 1 to 3, wherein an ultrasonic weld (10) is formed between the lower housing part (6) and the upper housing part (8).

5. Electric device (1) according to any one of claims 1 to 4, wherein the gap (16) extends in a radial direction (R) beyond the weld (10).

6. Electric device (1) according to any one of claims 1 to 5, wherein an inner gap (62) is provided, the inner gap (62) being arranged opposite the gap (16) relative to the protrusion (14) and extending radially from the protrusion (14) to the housing volume (12).

7. Electric device (1) according to claim 6, wherein the inner gap (62) opens radially into a slot-like pocket (46) formed between an outer sidewall (26) of one of the lower housing part (6) and upper housing part (8) and an inner wall (44) of the respective other one of the lower housing part (6) and upper housing part (8), the inner wall (44) being arranged in the housing volume (12) and extending essentially parallel to the sidewall (26).

8. Electric device (1) according to claim 6 or 7, wherein the notch (52) opens into the gap (16) and/or inner gap (62).

9. Electric device (1) according to any one of claims 1 to 8, wherein the gap (16) is arranged between a quarter and three quarter of a height of the housing (4).

10. Electric device (1) according to any one of claims 1 to 9, wherein the gap (16) is provided at mid-height of the housing (4).

11. Electric device (1) according to any one of claims 1 to 10, wherein an outer surface (32) of the upper housing part (8) is aligned with an outer surface (34) of the lower housing part (6).

12. Electric device (1) according to any one of claims 1 to 11, wherein a height of the gap (16) between the lower housing part (6) and upper housing part (8) is smaller than a length of the gap (16) in the radial direction (R).

13. Electric device (1) according to any one of claims 1 to 12, wherein only the protrusion of the respective one of the lower housing part (6) and the upper housing part (8) directly abuts the respective other one of the lower housing part (6) and the upper housing part (8).

14. Method for manufacturing a sealed housing (4) of an electric device (1), the housing (4) having a lower housing part (6) being adapted to support at least one electric component (2) and an upper housing part (8), wherein one of the lower housing part (6) and upper housing part (8) comprises a protrusion (14), the method comprising the step of welding the protrusion (14) to the respective other one of the lower housing part (6) and upper housing part (8) under formation of a gap (16) between lower housing part (6) and upper housing part (8) extending from the protrusion (14) in a radial direction (R) to outside (17) the housing (4).

15. Method according to claim 14, wherein a predetermined volume (60) of a tip (58) of the protrusion (14) is melted, the predetermined volume (60) being lower than a volume between front faces (24, 50) of the lower housing part (6) and upper housing part (8).

## Amended claims

### Amended claims in accordance with Rule 137(2) EPC.

1. Electric device (1), such as a relay (3), the electric device (1) comprising:
- electric components (2);
- a sealed housing (4) having:
- a lower housing part (6), on which at least one of the electric components (2) is supported; and
- an upper housing part (8), wherein an ultrasonic weld (10) is formed between the upper housing part (8) and the lower housing part (8);
the lower housing part (6) and the upper housing part (8) surrounding a housing volume (12), in which the electric components (2) are sealingly encased, wherein one of the lower housing part (6) and the upper housing part (8) comprises a protrusion (14), which is welded to the respective other one of the lower housing part (6) and upper housing part (8), and wherein a gap (16) is provided between lower housing part (6) and upper housing part (8), the gap (16) extending radially from the protrusion (14) to an outside (17) of the housing (4), and wherein solidified molten material (18) from the weld (10) is at least partially received in the gap (16), wherein an inner gap (62) is provided, the inner gap (62) being arranged opposite the gap (16) relative to the protrusion (14) and extending radially from the protrusion (14) to the housing volume (12), **characterized in that** the inner gap (62) opens radially into a slot-like pocket (46) formed between an outer sidewall (26) of one of the lower housing part (6) and upper housing part (8) and an inner wall (44) of the respective other one of the lower housing part (6) and upper housing part (8), the inner wall (44) being arranged in the housing volume (12) and extending essentially parallel to the sidewall (26).

2. Electric device (1) according to claim 1, wherein the protrusion (14) extends continuously along an entire front face (24) of the respective lower housing part (6) or upper housing part (8) and has a closed periphery.

3. Electric device (1) according to claim 1 or 2, wherein the protrusion (14) is at least partially received in a notch (52) of the respective other one of the lower housing part (6) and upper housing part (8) and wherein the weld (10) is at least partially arranged between protrusion (14) and notch (52).

4. Electric device (1) according to any one of claims 1 to 3, wherein the gap (16) extends in a radial direction (R) beyond the weld (10).

5. Electric device (1) according to any one of claims 1 to 4, wherein the notch (52) opens into the gap (16) and/or inner gap (62).

6. Electric device (1) according to any one of claims 1 to 5, wherein the gap (16) is arranged between a quarter and three quarter of a height of the housing (4).

7. Electric device (1) according to any one of claims 1 to 6, wherein the gap (16) is provided at mid-height of the housing (4).

8. Electric device (1) according to any one of claims 1 to 7, wherein an outer surface (32) of the upper housing part (8) is aligned with an outer surface (34) of the lower housing part (6).

9. Electric device (1) according to any one of claims 1 to 8, wherein a height of the gap (16) between the lower housing part (6) and upper housing part (8) is smaller than a length of the gap (16) in the radial direction (R).

10. Electric device (1) according to any one of claims 1 to 9, wherein only the protrusion of the respective one of the lower housing part (6) and the upper housing part (8) directly abuts the respective other one of the lower housing part (6) and the upper housing part (8).

11. Method for manufacturing a sealed housing (4) of an electric device (1), the housing (4) having a lower housing part (6) being adapted to support at least one electric component (2) and an upper housing part (8), wherein one of the lower housing part (6) and upper housing part (8) comprises a protrusion (14), the method comprising the step of ultrasonic welding the protrusion (14) to the respective other one of the lower housing part (6) and upper housing part (8) under formation of a gap (16) between lower housing part (6) and upper housing part (8) extending from the protrusion (14) in a radial direction (R) to outside (17) the housing (4) and under formation of an inner gap (62), the inner gap (62) being arranged opposite the gap (16) relative to the protrusion (14) and extending radially from the protrusion (14) to the housing volume (12), the inner gap (62) opening radially into a slot-like pocket (46) formed between an outer sidewall (26) of one of the lower housing part (6) and upper housing part (8) and an inner wall (44) of the respective other one of the lower housing part (6) and upper housing part (8), the inner wall (44) being arranged in the housing volume (12) and extending essentially parallel to the sidewall (26).

12. Method according to claim 11, wherein a predetermined volume (60) of a tip (58) of the protrusion (14) is melted, the predetermined volume (60) being lower than a volume between front faces (24, 50) of the lower housing part (6) and upper housing part (8).
